# EUROPÄISCHE PATENTSCHRIFT

(11) **EP 1 476 587 B1**
(45) Veröffentlichungstag und Bekanntmachung des Hinweises auf die Patenterteilung: **10.05.2006**
(21) Anmeldenummer: 03709598.1
(22) Anmeldetag: 01.02.2003
(51) Int. Cl.: C23C 14/06, F16J 9/26

(54) **KOLBENRING MIT EINER PVD-BESCHICHTUNG**
PISTON RING COMPRISING A PVD COATING
SEGMENT DE PISTON DOTE D'UN REVETEMENT APPLIQUE PAR DEPOT EN PHASE GAZEUSE PAR PROCEDE PHYSIQUE

(30) Priorität: 20.02.2002 DE 10207078
(43) Veröffentlichungstag der Anmeldung: 17.11.2004
(73) Patentinhaber: Federal-Mogul Burscheid GmbH, 51399 Burscheid (DE)
(72) Erfinder: FISCHER, Manfred, 42799 Leichlingen (DE); MÜNCHOW, Frank, 42929 Wermelskirchen (DE)
(86) Internationale Anmeldenummer: PCT/DE2003/000287
(87) Internationale Veröffentlichungsnummer: WO 2003/070999

(56) Entgegenhaltungen:
- EP-A- 0 603 486
- PATENT ABSTRACTS OF JAPAN vol. 017, no. 671 (M-1525), 10. Dezember 1993 (1993-12-10) & JP 05 223172 A (RIKEN CORP), 31. August 1993 (1993-08-31)
- PATENT ABSTRACTS OF JAPAN vol. 2002, no. 04, 4. August 2002 (2002-08-04) & JP 2001 335878 A (TEIKOKU PISTON RING CO LTD), 4. Dezember 2001 (2001-12-04)
- SUN Y ET AL: "COMBINED PLASMA NITRIDING AND PVD TREATMENTS" TRANSACTIONS OF THE INSTITUTE OF METAL FINISHING, INSTITUTE OF METAL FINISHING. LONDON, GB, Bd. 70, Nr. 1, 1. Februar 1992 (1992-02-01), Seiten 38-44, XP000261786 ISSN: 0020-2967
- PATENT ABSTRACTS OF JAPAN vol. 007, no. 268 (C-197), 30. November 1983 (1983-11-30) & JP 58 147559 A (HITACHI CONDENSER KK), 2. September 1983 (1983-09-02)

## Beschreibung

Kolbenring für eine Verbrennungskraftmaschine aus einem Eisenbasiswerkstoff, mit einer zumindest im Bereich der Lauffläche vorgesehenen Verschleißschutzschicht, die nach dem PVD- Verfahren aufgebracht ist und die im Wesentlichen aus Chromnitrid gebildet ist, wobei in die Verschleißschutzschicht Nitride eingelagert sind, und die Schichtdicke max. 70 µm beträgt.

Um den Anforderungen neuer Motorenentwicklungen gerecht zu werden, ist es zwingend erforderlich, dass die einem tribologischen Verschleiß unterliegenden Systemkomponenten Kolben, Kolbenring und Zylinderlaufbuchse optimal aufeinander abgestimmt sind. Insbesondere den Kolbenringen kommt dabei eine besondere Bedeutung zu. Um die geforderte Lebensdauer erfüllen zu können, werden die Laufflächen der Kolbenringe mit Verschleißschutzschichten versehen. Dabei belasten immer höhere Zylinderdrücke, Direkteinspritzung, Abgasrückführung, Minimierung des Ölverbrauchs und andere Konstruktionsmerkmale, die Kolbenringe dermaßen, dass init den herkömmlichen Kolbenringbeschichtungen die geforderten Lebensdauererwartungen nicht mehr gewährleistet werden können.

Um die Lebensdauererwartungen zu erhöhen, ist es allgemein üblich, die Laufflächen der Kolbenringe mit Verschleißschutzschichten zu versehen. Bekannte Verfahren nach denen diese Verschleißschutzschichten erzeugt werden, sind das Plasmaspritzen, das Nitrieren, galvanischen Verfahren oder Verfahren der Dünnschichttechnologie, wie das CVD- oder PVD-Verfahren. Zu den PVD-Verfahren gehören neben den Dampfabscheideprozessen auch die Kathodenzerstäubung bzw. Vakuumbedampfung sowie die Ionenplattierung.

In der DE 100 11 918 A1 ist ein Kolbenring für eine Verbrennungskraftmaschine mit einer, zumindest im Bereich der Laufflächen vorgesehenen Verschleißschutzschicht, die nach einem PVD- oder CVD-Verfahren aufgebracht ist, beschrieben. Die Verschleißschutzschicht ist im Wesentlichen dadurch gekennzeichnet, dass sie aus den Elementen Chrom, Kohlenstoff und Wasserstoff zusammengesetzt ist, wobei die Schichtdicke max. 100µm beträgt. Dabei kann die Schicht weitere Metallanteile, wie Titan, Niob, Wolfram, Tantal, und Nichtmetalle, wie Sauerstoff und Stickstoff, enthalten.
Die nach diesem Verfahren aufgebrachten Schichten verfügen über gute Festigkeits- und Brandspureigenschaften. Es hat sich aber gezeigt, dass sich derartige Verschleißschutzschichten nur in begrenzten Dicken ausführen lassen, so dass die geforderten Verschleißwerte die Forderungen an die Lebensdauer nicht erreichen. Somit sind diese Schichten in neueren Motoren nicht anwendbar.

Zur Steigerung der Verschleißbeständigkeit wird in der US 5,960,762 ein Kolbenring vorgeschlagen, der an seiner Lauffläche mit einer Verschleißschutzschicht versehen ist, die nach dem PVD-Verfahren erzeugt ist. Die Verschleißschutzschicht kann im Wesentlichen aus Chrom-Nitriden und/oder Titan-Nitriden bestehen.
Die nach diesem Verfahren erzeugte Verschleißschutzschicht verfügt zwar über gute Festigkeits- und Brandspureigenschaften, die Verschleißfestigkeit dieser Schicht ist jedoch nicht ausreichend hoch. Da sich diese Schichten auch nur in begrenzten Dicken ausführen lassen, werden die Forderungen an die Lebensdauer nicht erreicht, so dass sie, insbesondere für Motoren mit hoher Leistung, nicht optimal eingesetzt werden können.
Ein Hinweis darauf, dass als Nitridbildner die Elemente Aluminium, Silizium oder Zirkonium eingesetzt werden können, kann dieser Schrift nicht entnommen werden.

Aus der JP 05 223172 A ist ein Kolbenring mit einer im Wesentlichen aus Chromnitird besthenden Schicht mit einer Stärke von 1- 40 µm, in die Siliziumnitrid eingelagert ist, bekannt. Eine Aussage über Aluminium- oder Zirkoniumnitride ist dieser Schrift nicht zu entnehmen.
Um die technischen Nachteile des Standes der Technik zu überwinden, liegt der Erfindung die Aufgabe zugrunde, einen Kolbenring mit einer Verschleißschutzschicht zu versehen, die das Funktionsverhalten, d. h. die Brandspursicherheit und das Eigenverschleißverhalten, verbessert und dadurch die Lebensdauererwartung des Kolbenringes wesentlich steigert.

Die Aufgabe wird erfindungsgemäß durch die Merkmale des Patentanspruch 1 gelöst.

Vorteilhafte Weiterbildungen des erfindungsgemäßen Kolbenringes sind in den Unteransprüchen dokumentiert.

Die Erfindung ermöglicht es nun, einen Kolbenring mit einer Verschleißschutzschicht herzustellen, der sich durch ein hohes Eigenverschleißverhalten auszeichnet und gute Reibeigenschaften aufweist. Die erfindungsgemäße Schicht besitzt eine hohe innere Festigkeit und läßt sich bei entsprechender Vorbehandlung mit ausgezeichneter Haftung auf die Kolbenringbasiswerkstoffe, wie Stahl und Gußeisen, aufbringen. Sie verfügt darüber hinaus über eine hohe Brandspursicherheit und greift den Gegenpartner, nämlich die Zylinderlaufbuchse, nicht an. Die Verschleißschutzschicht ist korrosionsfest gegenüber den im Verbrennungsraum auftretenden Medien und besitzt eine hohe Wärmeleitfähigkeit, um den Wärmetransport vom Verbrennungsraum über Kolben und Kolbenringe an die Zylinderlauffläche gut ausführen zu können.

Die aus dem Stand der Technik bekannten Chrom-Nitrid-Schichten, die mittels eines PVD-Verfahrens abgeschieden werden und die mit und ohne Zusätze an Sauerstoff und Kohlenstoff ausgeführt sein können, weisen zwar eine hohe Brandspursicherheit und Eigenverschleißfestigkeit auf, diese reicht aber nicht aus, um mit den realisierbaren Schichtdicken die geforderte Lebensdauer der Kolbenringe zu gewährleisten.
Durch den erfindungsgemäßen Einbau weiterer nitridbildender Elemente wie Aluminium oder Zirkonium wird die Eigenverschleißfestigkeit der Schicht verbessert, ohne den Verschleiß des Gegenpartners negativ zu beeinflussen.

Neben dem Einbau eines weiteren Elementes in die Chrom-Nitrid-Schicht ist es erfindungsgemäß auch vorstellbar, eine Kombination aus mehreren der genannten Elemente in die Schicht zu integrieren. Grundsätzlich ist jede Kombination dieser Elemente vorstellbar. Möglich ist eine Chrom-Aluminium-Silizium-Nitrid-Schicht, eine Chrom-Aluminium-Silizium- Zirkonium-Nitrid-Schicht, eine Chrom-Aluminium-Zirkonium-Nitrid-Schicht wie auch jede andere Kombination an Elementen. Zu beachten bleibt hierbei, dass der Anteil der Elemente in der Schicht in der Summe nicht weniger als 10 Atom-% und nicht mehr als 50 Atom-% beträgt, wobei der Gesamtmetallgehalt in der Schicht zwischen 50 und 70 Atom-% liegen sollte.

In einem ersten Ausgestaltungsbeispiel wird in der Erfindung vorgeschlagen, die Chrom-Nitrid-Schicht mit Aluminium zu versehen. Dabei liegen die Elementargehalte in der Verschleißschutzschicht bei 20-60 Atom-% Chrom, 10-50 Atom-% Aluminium und 30-50 Atom-% Stickstoff. Der Metallgehalt in der Schicht sollte dabei nicht weniger als 50 Atom-% und nicht mehr als 70 Atom-% betragen.

In einem zweiten Ausgestaltungsbeispiel wird in der Erfindung vorgeschlagen, die Chrom-Nitrid-Schicht mit Zirkonium zu versehen. Dabei liegen die Elementargehalte in der Verschleißschutzschicht bei 20-60 Atom-% Chrom, 10-50 Atom-% Zirkonium und 30-50 Atom-% Stickstoff. Der Metallgehalt in der Schicht sollte dabei nicht weniger als 50 Atom-% und nicht mehr als 70 Atom-% betragen.

In einem dritten Ausgestaltungsbeispiel wird in der Erfindung vorgeschlagen, den Kolbenring aus Stahl zu fertigen und vor dem Auftragen der Verschleißschutzschicht einer Nitrierbehandlung zu unterziehen. Dabei wird der Kolbenring zuerst nach einem üblichen Verfahren, zumindest an seiner Lauffläche, nitriert, anschließend wird die erfindungsgemäße Verschleißschutzschicht mittels eines PVD-Verfahrens aufgebracht.

Der Erfindungsgegenstand ist anhand eines Ausführungsbeispiels in der Zeichnung dargestellt und wird wie folgt beschrieben. Es zeigt:

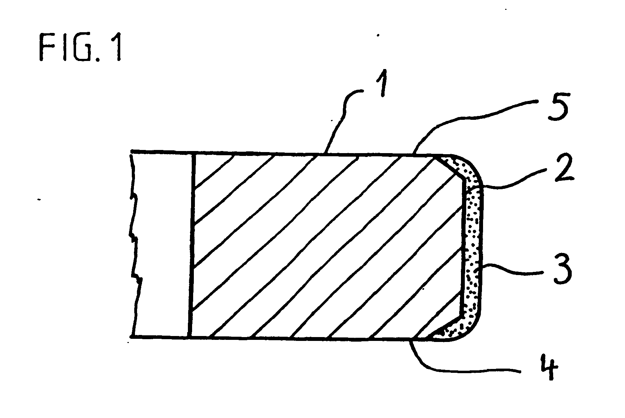

Figur 1 Kompressionskolbenring mit laufflächenseitiger Verschleißschutzschicht

Die Figur 1 zeigt einen aus einer Eisenbasislegierung bestehenden Kompressionskolbenring 1, der im Bereich seiner Lauffläche 2 mit einer Verschleißschutzschicht 3 versehen ist. Die Verschleißschutzschicht 3 ist in diesem Ausführungsbeispiel lediglich an der Lauffläche 2 angeordnet, kann sich aber auch über Teile der Flanken 4, 5 erstrecken. Im Wesentlichen besteht die Verschleißschutzschicht 3 aus Chrom-Nitrid, wobei in die Chrom-Nitrid-Schicht Nitride aus mindestens einem der Elemente Al oder Zr eingelagert sind.

## Patentansprüche

1. Kolbenring für eine Verbrennungskraftmaschine aus einem Eisenbasiswerkstoff, mit einer zumindest im Bereich der Lauffläche (2) vorgesehenen Verschleißschutzschicht (3), die nach dem PVD-Verfahren aufgebracht ist und die im Wesentlichen aus Chrom-Nitrid gebildet ist, wobei in die Verschleißschutzschicht (3) Nitride eingelagert sind, und die Schichtdicke max. 70 µm beträgt, **dadurch gekennzeichnet, dass** die Nitride aus den Elementen Aluminium und/oder Zirkonium gebildet sind wobei die Verschleißschutzschicht (3) 20-60 Atom-% Chrom, 10-50 Atom-% Aluminium und/oder 10-50Atom-% Zirkonium und 30-50 Atom-% Stickstoff enthält, wobei der Gesamtanteil der Elemente Chrom und Aluminium oder Zirkonium in der Schicht (3) zwischen 50 und 70 Atom-% beträgt.

2. Kolbenring nach Anspruch 1, **dadurch gekennzeichnet, dass** die Nitride in der Verschleißschutzschicht (3) aus den Elementen Aluminium und Zirkonium gebildet ist, wobei der Gesamtanteil der Elemente in der Schicht zwischen 10 und 50 Atom-% beträgt und dass der Gesamtmetallgehalt in der Schicht (3) zwischen 50 und 70 Atom-% liegt.

3. Kolbenring nach einem der Ansprüche 1 bis 2, **dadurch gekennzeichnet, dass** der Kolbenring (1) aus Stahl gefertigt ist und dass der Kolbenring (1) vor dem Auftragen der Verschleißschutzschicht (3) eine Nitrierbehandlung erfahren hat.

## Claims

1. Piston ring for an internal combustion engine comprising an iron base material, having an anti-abrasion layer (3) which is provided at least in the region of the running face (2), said anti-abrasion layer being applied according to the PVD process and being formed essentially from chromium nitride, nitrides being incorporated in the anti-abrasion layer (3) and the layer thickness being at most 70 µm, **characterised in that** the nitrides are formed from the elements aluminium and/or zirconium, the anti-abrasion layer (3) containing 20 - 60% by atom chromium, 10 - 50% by atom aluminium and/or 10 - 50% by atom zirconium and 30 - 50% by atom nitrogen, the total proportion of the elements chromium and aluminium or zirconium in the layer (3) being between 50 and 70% by atom.

2. Piston ring according to claim 1, **characterised in that** the nitrides in the anti-abrasion layer (3) are formed from the elements aluminium and zirconium, the total proportion of the elements in the layer being between 10 and 50% by atom and **in that** the total metal content in the layer (3) is between 50 and 70% by atom.

3. Piston ring according to one of the claims 1 to 2, **characterised in that** the piston ring (1) is produced from steel and **in that** the piston ring (1) has undergone a nitriding treatment before application of the anti-abrasion layer (3).

## Revendications

1. Segment de piston pour une machine à combustion interne, constitué d'un matériau à base de fer, doté d'une couche de protection contre l'usure (3) prévue au moins dans la zone de la surface de roulement (2), qui est déposée d'après le procédé PVD et qui est sensiblement constituée de nitrure de chrome, où des nitrures sont incorporés dans la couche de protection contre l'usure (3) et l'épaisseur de couche atteint au maximum 70 µm, **caractérisé en ce que** les nitrures se composent des éléments aluminium et/ou zirconium, où la couche de protection contre l'usure (3) contient de 20 à 60 % atomique de chrome, 10 à 50 % atomique d'aluminium et/ou 10 à 50 % atomique de zirconium et de 30 à 50 % atomique d'azote, où la teneur totale en éléments chrome et aluminium ou zirconium dans la couche (3) se situe entre 50 % atomique et 70 % atomique.

2. Segment de piston selon la revendication 1, **caractérisé en ce que** les nitrures dans la couche de protection contre l'usure (3) se composent des éléments aluminium et zirconium, où la teneur totale en éléments dans la couche se situe entre 10 et 50 % atomique et **en ce que** la teneur en métaux totale dans la couche (3) se situe entre 50 et 70 % atomique.

3. Segment de piston selon l'une des revendications 1 à 2, **caractérisé en ce que** le segment de piston (1) est confectionné en acier et **en ce que** le segment de piston (1) a subi un traitement de nitration avant le dépôt de la couche de protection contre l'usure (3).
